# EUROPEAN PATENT APPLICATION

(11) **EP 4 651 656 A1**
(43) Date of publication of application: **19.11.2025**
(21) Application number: 24215899.6
(22) Date of filing: 27.11.2024
(51) Int. Cl.: H05K 7/20, H05K 7/14

(54) **SINGLE-PHASE IMMERSION LIQUID-COOLING CABINET**

(30) Priority: 17.05.2024 CN 202421087988 U
(71) Applicant: Vertiv Corporation, Westerville, OH 43082 (US)
(72) Inventor: MENG, Lei, Xi an, 710005 (CN); SU, Qi, Xi an, 710005 (CN); MA, Yuanbo, Xi an, 710005 (CN); WANG, Fei, Xi an, 710005 (CN)
(74) Representative: Morrall, Jonathan Ian McLachlan

(57) **Abstract**

The present application discloses an immersion liquid-cooling cabinet comprising: a cabinet body; a liquid containing tank body mounted in the cabinet body for containing a cooling liquid; at least one server mounting position provided within the liquid containing tank body; at least one switch mounting position vertically provided around the liquid containing tank body; a cable-passing device assembly fixedly mounted on top of the switch mounting position, within which a cable of a switch mounted at the corresponding switch mounting position is routed. The structure of the immersion liquid-cooling cabinet gives full consideration to the layout, installation and wiring of the switch, thereby improving the rationality of the overall structure; and an integrated installation technology for the switch and the server is adopted, so that the immersion liquid-cooling cabinet is more compact in space utilization and more neat and beautiful in appearance.

## Description

### FIELD

The present application belongs to the technical field of data center refrigeration, and in particular relates to a single-phase immersion liquid-cooling cabinet.

### BACKGROUND

In the current technical field of data center refrigeration, single-phase immersion liquid-cooling technology has been widely used in a cabinet to achieve efficient heat dissipation for a server and other heat-loaded apparatus. However, the existing technologies mainly focus on optimizing the installation, layout and wiring path of the server, while ignoring the cooling requirements of the switch, which is an equally important communication apparatus in the data center. As an indispensable and critical assembly in the data center, the stable operation of the switch is very important to ensure the efficiency and reliability of data transmission.

In the application scenario of the single-phase immersion liquid-cooling cabinet, if the installation, layout and wiring of the switch are not comprehensively considered, the on-site layout will be difficult, and non-standardized temporary layout may be required. This not only affects the customer experience, but may also have a negative impact on the normal operation and maintenance of the apparatus. In addition, the existing technology fails to fully recognize the difference of cooling requirements between the switch and the server in an immersion liquid-cooling environment, as well as the challenges brought by this difference to the overall system design. Therefore, the existing technology has not yet been able to provide a single-phase immersion liquid-cooling cabinet solution that comprehensively considers the cooling requirements of the server and the switch, thereby limiting the further improvements in energy efficiency and the simplification of maintenance of the data center.

### SUMMARY

In view of the technical problems to be solved of the present application, there is provided a single-phase immersion liquid-cooling cabinet, which may meet the cooling requirements of the server and the switch at the same time and improve the standardization level of the on-site layout.

In order to solve the above technical problems, following technical solutions are provided according to the present application.

An immersion liquid-cooling cabinet includes:
- a cabinet body;
- a liquid containing tank body mounted in the cabinet body for containing a cooling liquid;
- at least one server mounting position provided within the liquid containing tank body;
- at least one switch mounting position vertically provided around the liquid containing tank body;
- a cable-passing device assembly fixedly mounted on top of the switch mounting position, within which a cable of a switch mounted at the corresponding switch mounting position is routed.

The structure of the immersion liquid-cooling cabinet gives full consideration to the layout, installation and wiring of the switch, thereby improving the rationality of the overall structure; and an integrated installation technology for the switch and the server is adopted, so that the immersion liquid-cooling cabinet is more compact in space utilization and more neat and beautiful in appearance.

Further, the cable-passing device assembly comprises a rear cable-passing device, and the rear cable-passing device is mounted at the rear of the liquid containing tank body. The preferred technical solution is suitable for the case that the switch is mounted at the rear of the liquid containing tank body, and the rear cable-passing device may correspond to the switch provided at the rear of the liquid containing tank body.

Further, the rear cable-passing device is provided with a rear cable-passing hole penetrating through the bottom and the top of the rear cable-passing device. The cable of the switch passes through the rear cable-passing holes and is connected to other components, so that the internal wiring of the immersion liquid-cooling cabinet structure is neat and beautiful.

Further, the rear cable-passing device includes multiple cable-passing side plates that are enclosed together to form the rear cable-passing hole.

Further, the rear cable-passing device further includes a fixing plate and a cable fixing structure, the cable fixing structure is fixedly mounted on the fixing plate; the fixing plate is fixedly connected to the cable-passing side plate proximate the liquid containing tank body and extends obliquely from the top of the cable-passing side plate to the liquid containing tank body. The cable of the switch passes through the rear cable-passing hole and then passes through the cable fixing structure for fixing, thereby preventing the cable from leaving the rear cable-passing hole under gravity or from being in poor contact with other components under gravity.

Further, the cable-passing device assembly includes a side cable-passing device, and the side cable-passing device is mounted at a side of the liquid containing tank body. The preferred technical solution is suitable for the case that the switch is mounted at the side of the liquid containing tank body, and the side cable-passing device may correspond to the switch provided at the side of the liquid containing tank body.

Further, the side cable-passing device is provided with a first side cable-passing hole and a second side cable-passing hole, the first side cable-passing hole is formed at the bottom of the side cable-passing device, and the second side cable-passing hole is formed on a side wall of the side cable-passing device away from the liquid containing tank body. The preferred technical solution makes full use of the internal space of the cabinet body for wiring, so that the wiring inside the immersion liquid-cooling cabinet structure is neat and beautiful.

Further, the server mounting position is provided along the length direction of the cabinet body, and the server mounting position is used for accommodating one server or a plurality of servers stacked along the length direction of the cabinet body. The server and the switch are perfectly integrated into the cabinet structure, and the overall structure of the cabinet is compact and beautiful.

Further, multiple switch mounting positions are provided at a side of the liquid containing tank body and/or arranged in a row at the rear of the liquid containing tank body. The server and the switch are perfectly integrated into the cabinet structure, and the overall structure of the cabinet is compact and beautiful.

Further, the cabinet body includes multiple side cover plates and a top cover plate, the top cover plate is hingedly connected to one of the side cover plates, so as to facilitate the installation and maintenance of the cabinet body.

The present application has the following beneficial effects.

The structure of the immersion liquid-cooling cabinet gives full consideration to the layout, installation and wiring of the switch, thereby improving the rationality of the overall structure; and an integrated installation technology for the switch and the server is adopted, so that the immersion liquid-cooling cabinet is more compact in space utilization and more neat and beautiful in appearance.

### BRIEF DESCRIPTION OF THE DRAWINGS

FIG. 1 is a schematic perspective view of an immersion liquid-cooling cabinet in one embodiment of the present application;
FIG. 2 is a top view of the immersion liquid-cooling cabinet in one embodiment of the present application;
FIG. 3 is a partially enlarged schematic view of A in FIG. 1;
FIG. 4 is a schematic perspective view of the immersion liquid-cooling cabinet in one embodiment of the present application viewed from another angle;
FIG. 5 is a partially enlarged schematic view of B in FIG. 4.

Reference numerals in the drawings are as follows:

| | | | |
|---|---|---|---|
| 100 | - cabinet body; | 110 | - side cover plate; |
| 120 | - top cover plate; | 200 | - server mounting position; |
| 300 | - switch mounting position; | | |
| 400 | - liquid containing tank body; | 500 | - cable-passing device assembly; |
| 510 | - rear cable-passing device; | 511 | - rear cable-passing hole; |
| 512 | - cable-passing side plate; | 513 | - fixing plate; |
| 514 | - cable fixing structure; | 520 | - side cable-passing device; |
| 521 | - first side cable-passing hole; | 522 | - second side cable-passing hole. |

### DETAILED DESCRIPTION OF THE EMBODIMENTS

In order to make the technical problems to be solved by the present application, and technical solutions, beneficial effects of the present application more clearly, the present application will be further described in detail in combination with the accompanying drawings and embodiments. It should be understood that specific embodiments described herein are only used for explaining the present application and are not intended to limit the present application.

It should be noted that, if an element is referred to as being "fixed to" or "provided on" another element, the former element can be directly on the latter element, or indirectly on the latter element. If an element is referred to as being "connected" to another element, the former element can be directly connected to the latter element, or indirectly connected to the latter element.

It should be understood that the orientation or positional relationship indicated by the terms, such as "length", "width", "upper", "lower", "front", "rear", "left", "right", "vertical", "horizontal", "top", "bottom", "inner", and "outer", are based on the orientation or positional relationship shown in the accompanying drawings, which are only used to facilitate the description of the present application and to simplify the description, rather than indicating or implying that the device or element referred to must have a specific orientation, or can only be configured and operated in a particular orientation. Therefore, the above terms should not be interpreted as a limitation to the present application.

In addition, the terms "first", "second" and the like are for purpose of description, and should not be interpreted as indicating or implying relative importance or implying the number of the indicated technical features. Therefore, the features defined by "first" and "second" may explicitly or implicitly include one or more such features. In the description of the present application, the meaning of "multiple" is two or more, unless specifically defined otherwise.

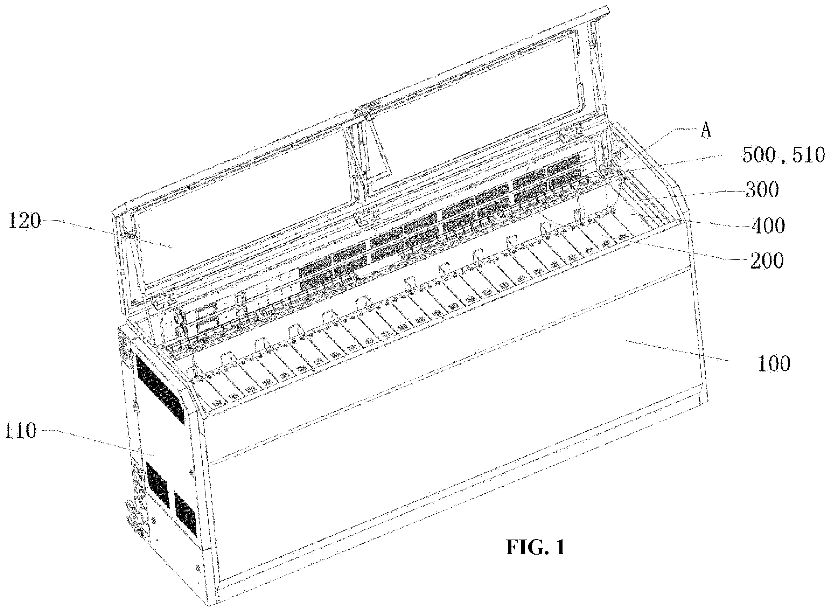

Please refer to FIG. 1 in which a preferred embodiment of the present application is shown, an immersion liquid-cooling cabinet includes: a cabinet body 100; a liquid containing tank body 400 which is mounted in the cabinet body 100 and is configured for containing a cooling liquid; at least one server mounting position 200 provided within the liquid containing tank body 400; at least one switch mounting position 300 vertically provided around the liquid containing tank body 400; a cable-passing device assembly 500 fixedly mounted on top of the switch mounting position 300, and a cable of the switch mounted at the corresponding switch is routed within the cable-passing device assembly 500.

The structure of the immersion liquid-cooling cabinet gives full consideration to the layout, installation and wiring of the switch, thereby improving the rationality of the overall structure; and an integrated installation technology for the switch and the server is adopted, so that the immersion liquid-cooling cabinet is more compact in space utilization and more neat and beautiful in appearance. The immersion liquid-cooling cabinet provides an effective solution to the technical shortcomings of most immersion liquid-cooling air-conditioning cabinets at present.

The immersion liquid-cooling cabinet mainly includes a cabinet body 100, a server mounting position 200, a switch mounting position 300, a liquid containing tank body 400 and a cable-passing device assembly 500. Each of the above components is described in further detail below.

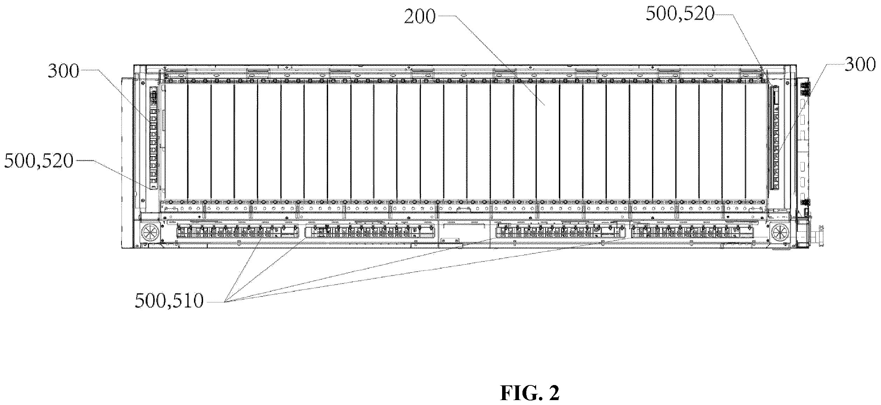

As shown in FIG. 1 and FIG. 2, the whole cabinet body 100 has a substantially rectangular box shape, and is provided with a chamber for accommodating the server mounting position 200, the switch mounting position 300, the liquid containing tank body 400 and the cable-passing device assembly 500. Specifically, the cabinet body 100 includes a bottom plate (not shown), multiple side cover plates 110 and a top cover plate 120, wherein, the bottom plate is provided opposite to the top cover plate 120; the multiple side cover plates 110 are connected end to end in sequence and provided between the bottom plate and the top cover plate 120; the top cover plate 120 is hingedly connected to a top end of one of the side cover plates 110; and one of the side cover plates 110 may also be hingedly connected to another side cover plate 110 adjacent thereto.

The liquid containing tank body 400 is mounted in the middle of the chamber of the cabinet body 100, and is provided with an opening (not marked in the drawing) at the top for containing the cooling liquid. The server mounting position 200 is provided within the liquid containing tank body 400. The server mounting position 200 is used for mounting a server, and the server is mounted in the server mounting position 200 via the opening. For the convenience of understanding, the specific embodiment and the accompanying drawings of the present application will be described by taking the server mounting position 200 having a server mounted therein as an example. For example, there is only one server in the server mounting position 200, alternatively, multiple servers are stacked in the server mounting position 200 along the length direction of the cabinet body 100.

Depending on actual needs, the number of the switch mounting positions 300 is configured as one or more. The switch mounting position 300 is vertically provided around the liquid containing tank body 400. Specifically, in one embodiment, multiple switch mounting positions 300 are provided at the side of the liquid containing tank body 400 and/or arranged in a row at the rear of the liquid containing tank body 400. The switch mounting position 300 is used for mounting a switch. For ease of understanding, the specific embodiments and the accompanying drawings of the application will be described by taking the switch mounting position 300 having a switch already mounted therein as an example. For example, only one switch is provided in the switch mounting position 300, alternatively, multiple switches are stacked in the switch mounting position 300 provided at the side of the liquid containing tank body 400 along the length direction of the cabinet body 100, the switch mounting positions 300 provided at the rear of the liquid containing tank body 400 are arranged in a row, and the switch mounting positions 300 correspond to switches one by one. The cable-passing device assembly 500 is fixedly mounted on top of the switch mounting position 300, and is corresponded to the switch mounting position 300 provided at the side of the liquid containing tank body 400 and/or to the switch mounting position 300 provided at the rear of the liquid containing tank body 400. The cable of the switch mounted in the corresponding switch mounting position 300 is provided to be routed within the cable-passing device assembly 500, which allows for rational wiring, and also for being neat and beautiful.

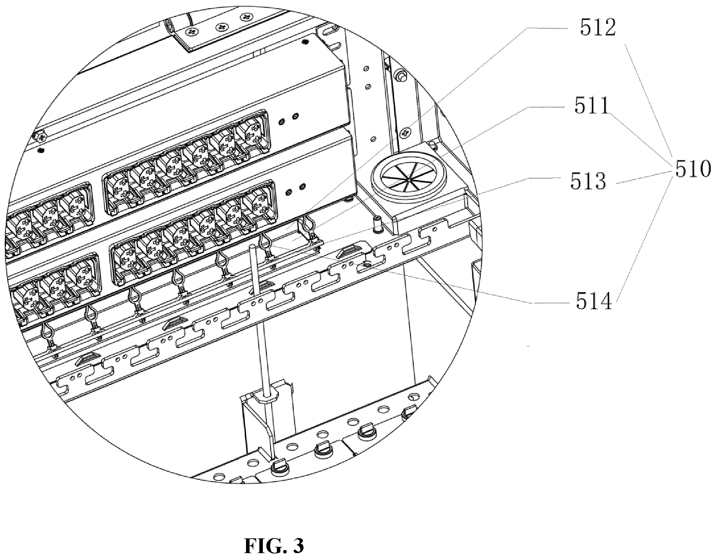

Specifically, as shown in FIG. 1, in one embodiment of the present application, the cable-passing device assembly 500 includes a rear cable-passing device 510 mounted at the rear of the liquid containing tank body 400, and the rear cable-passing device 510 may correspond to the switch mounting position 300 provided at the rear of the liquid containing tank body 400. Specifically, as shown in FIG. 3, the rear cable-passing device 510 is provided with a rear cable-passing hole 511 penetrating through the bottom and the top of the rear cable-passing device 510. The rear cable-passing device 510 includes multiple cable-passing side plates 512, and the multiple cable-passing side plates 512 are enclosed together to form the elongated rear cable-passing hole 511. Preferably, the rear cable-passing device 510 further includes a fixing plate 513 and a cable fixing structure 514. The fixing plate 513 is fixedly connected to the cable-passing side plate 512 proximate to the liquid containing tank body 400 and extends obliquely from the top of the cable-passing side plate 512 to the liquid containing tank body 400. The cable fixing structure 514 is fixedly mounted on the fixing plate 513, and is substantially annular. The cable of the switch passes through the rear cable-passing hole 511 and then passes through the cable fixing structure 514 for fixing.

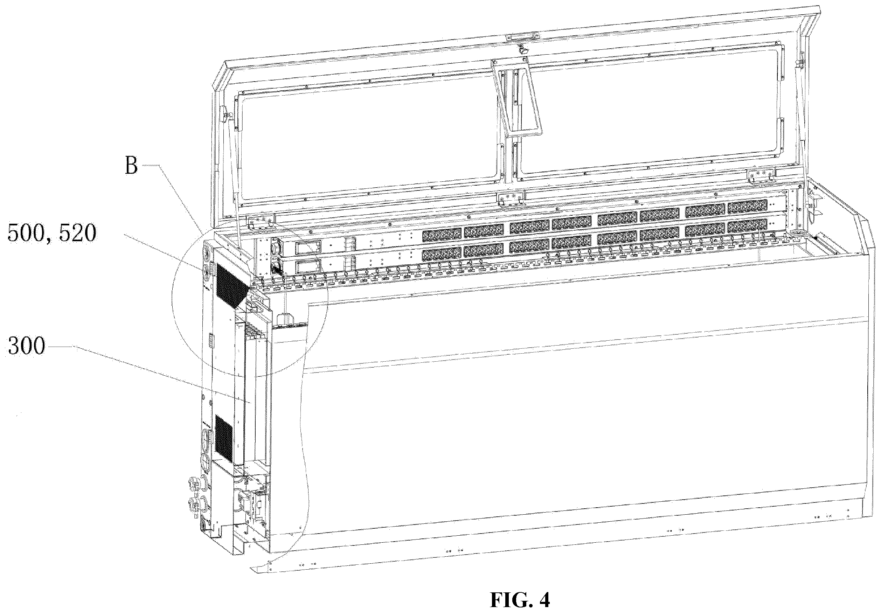

As shown in FIG. 4, in one embodiment of the present application, the cable-passing device assembly 500 includes a side cable-passing device 520. The side cable-passing device 520 is mounted at a side of the liquid containing tank body 400 and may correspond to the switch mounting position 300 provided at the side of the liquid containing tank body 400. Depending on the actual needs, the cable-passing device assembly 500 may include only one of the rear cable-passing device 510 and the side cable-passing device 520; alternatively, the cable-passing device assembly 500 may include both the rear cable-passing device 510 and the side cable-passing device 520.

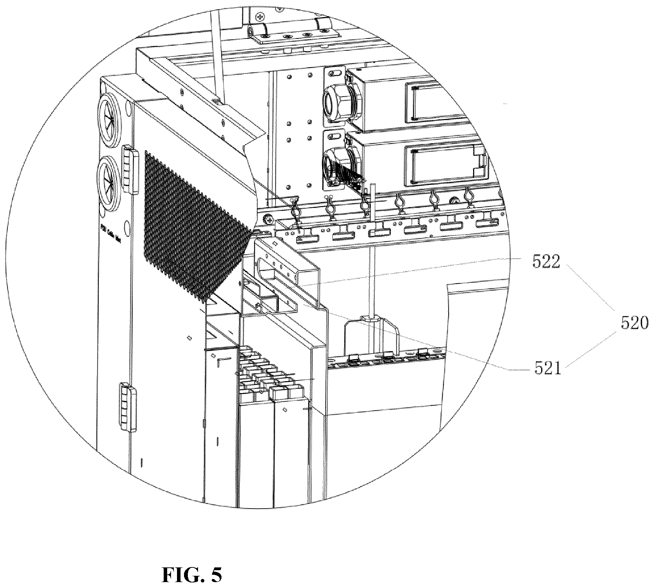

As shown in FIG. 5, specifically, the side cable-passing device 520 is provided with a first side cable-passing hole 521 and a second side cable-passing hole 522. The first side cable-passing hole 521 is formed at the bottom of the side cable-passing device 520. The second side cable-passing hole 522 is formed on a side wall of the side cable-passing device 520 away from the liquid containing tank body 400. Preferably, the lowest part of the second side cable-passing hole 522 is higher than the fundamental surface by a certain height.

The structure of the immersion liquid-cooling cabinet has an integrated layout and wiring technology of the switch and the server, so that the server and the switch are perfectly integrated into the cabinet structure, and the overall structure of the cabinet is compact and beautiful.

The above contents are only the preferred embodiments of the present application. For ordinary technicians in this field, based on the idea of the present application, many changes can be made in the specific implementation and application scope. As long as these changes do not depart from the concept of the present application, they all belong to the protection scope of the present application.

## Claims

1. An immersion liquid-cooling cabinet, **characterized in that** the immersion liquid-cooling cabinet comprises:
- a cabinet body (100);
- a liquid containing tank body (400) mounted in the cabinet body (100) for containing a cooling liquid;
- at least one server mounting position (200) provided within the liquid containing tank body (400);
- at least one switch mounting position (300) vertically provided around the liquid containing tank body (400);
- a cable-passing device assembly (500) fixedly mounted on top of the switch mounting position (300), within which a cable of a switch mounted at the corresponding switch mounting position (300) is routed.

2. The immersion liquid-cooling cabinet according to claim 1, **characterized in that** the cable-passing device assembly (500) comprises a rear cable-passing device (510) mounted at the rear of the liquid containing tank body (400).

3. The immersion liquid-cooling cabinet according to claim 2, **characterized in that** the rear cable-passing device (510) is provided with a rear cable-passing hole (511) penetrating through the bottom and the top thereof.

4. The immersion liquid-cooling cabinet according to claim 3, **characterized in that** the rear cable-passing device (510) comprises multiple cable-passing side plates (512) that are enclosed together to form the rear cable-passing hole (511).

5. The immersion liquid-cooling cabinet according to claim 4, **characterized in that** the rear cable-passing device (510) further comprises a fixing plate (513) and a cable fixing structure (514), the cable fixing structure (514) is fixedly mounted on the fixing plate (513); the fixing plate (513) is fixedly connected to the cable-passing side plate (512) proximate to the liquid containing tank body (400) and extends obliquely from the top of the cable-passing side plate (512) to the liquid containing tank body (400).

6. The immersion liquid-cooling cabinet according to any one of claims 1-5, **characterized in that** the cable-passing device assembly (500) comprises a side cable-passing device (520) mounted at a side of the liquid containing tank body (400).

7. The immersion liquid-cooling cabinet according to claim 6, **characterized in that** the side cable-passing device (520) is provided with a first side cable-passing hole (521) and a second side cable-passing hole (522), the first side cable-passing hole (521) is formed at the bottom of the side cable-passing device (520); the second side cable-passing hole (522) is formed on a side wall of the side cable-passing device (520) away from the liquid containing tank body (400).

8. The immersion liquid-cooling cabinet according to claim 1, **characterized in that** the server mounting position (200) is provided along the length direction of the cabinet body (100), and the server mounting position (200) is used for accommodating one server or a plurality of servers stacked along the length direction of the cabinet body (100).

9. The immersion liquid-cooling cabinet according to claim 1, **characterized in that** a plurality of switch mounting positions (300) are provided at a side of the liquid containing tank body (400) and/or arranged in a row at the rear of the liquid containing tank body (400).

10. The immersion liquid-cooling cabinet according to claim 1, **characterized in that** the cabinet body (100) comprises multiple side cover plates (110) and a top cover plate (120), the top cover plate (120) is hingedly connected to one of the side cover plates (110).

## Amended claims

### Amended claims in accordance with Rule 137(2) EPC.

1. An immersion liquid-cooling cabinet, the immersion liquid-cooling cabinet comprising:
- a cabinet body (100);
- a liquid containing tank body (400) mounted in the cabinet body (100) for containing a cooling liquid;
- at least one server mounting position (200) provided within the liquid containing tank body (400);
- at least one switch mounting position (300) vertically provided around the liquid containing tank body (400);
- a cable-passing device assembly (500) fixedly mounted on top of the switch mounting position (300),
**characterized in that**,
- a cable of a switch mounted at the corresponding switch mounting position (300) is routed within the cable-passing device assembly (500).

2. The immersion liquid-cooling cabinet according to claim 1, **characterized in that** the cable-passing device assembly (500) comprises a rear cable-passing device (510) mounted at the rear of the liquid containing tank body (400).

3. The immersion liquid-cooling cabinet according to claim 2, **characterized in that** the rear cable-passing device (510) is provided with a rear cable-passing hole (511) penetrating through the bottom and the top thereof.

4. The immersion liquid-cooling cabinet according to claim 3, **characterized in that** the rear cable-passing device (510) comprises multiple cable-passing side plates (512) that are enclosed together to form the rear cable-passing hole (511).

5. The immersion liquid-cooling cabinet according to claim 4, **characterized in that** the rear cable-passing device (510) further comprises a fixing plate (513) and a cable fixing structure (514), the cable fixing structure (514) is fixedly mounted on the fixing plate (513); the fixing plate (513) is fixedly connected to the cable-passing side plate (512) proximate to the liquid containing tank body (400) and extends obliquely from the top of the cable-passing side plate (512) to the liquid containing tank body (400).

6. The immersion liquid-cooling cabinet according to any one of claims 1-5, **characterized in that** the cable-passing device assembly (500) comprises a side cable-passing device (520) mounted at a side of the liquid containing tank body (400).

7. The immersion liquid-cooling cabinet according to claim 6, **characterized in that** the side cable-passing device (520) is provided with a first side cable-passing hole (521) and a second side cable-passing hole (522), the first side cable-passing hole (521) is formed at the bottom of the side cable-passing device (520); the second side cable-passing hole (522) is formed on a side wall of the side cable-passing device (520) away from the liquid containing tank body (400).

8. The immersion liquid-cooling cabinet according to claim 1, **characterized in that** the server mounting position (200) is provided along the length direction of the cabinet body (100), and the server mounting position (200) is used for accommodating one server or a plurality of servers stacked along the length direction of the cabinet body (100).

9. The immersion liquid-cooling cabinet according to claim 1, **characterized in that** a plurality of switch mounting positions (300) are provided at a side of the liquid containing tank body (400) and/or arranged in a row at the rear of the liquid containing tank body (400).

10. The immersion liquid-cooling cabinet according to claim 1, **characterized in that** the cabinet body (100) comprises multiple side cover plates (110) and a top cover plate (120), the top cover plate (120) is hingedly connected to one of the side cover plates (110).
